Europäisches Patentamt

European Patent Office

Office européen des brevets

(11) Numéro de publication: **0 466 080 A1**

## (12) DEMANDE DE BREVET EUROPEEN

(21) Numéro de dépôt: **91111356.1**

(22) Date de dépôt: **08.07.91**

(51) Int. Cl.⁵: **H03J 7/02**

(30) Priorité: **10.07.90 FR 9008753**

(43) Date de publication de la demande:
**15.01.92 Bulletin 92/03**

(84) Etats contractants désignés:
**AT BE CH DE ES FR GB IT LI NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

㊹ **DE ES FR GB IT NL SE**

Demandeur: **ALCATEL N.V.**
**Strawinskylaan 341**
**NL-1077 XX Amsterdam(NL)**

㊹ **BE CH LI AT**

(72) Inventeur: **Bonin, Jean-Pierre**
**26, boulevard du Château**
**F-92200 Neuilly sur Seine(FR)**
Inventeur: **Bursztejn, Jacques**
**67, boulevard Richard Lenoir**
**F-75011 Paris(FR)**

(74) Mandataire: **Weinmiller, Jürgen et al**
**Lennéstrasse 9 Postfach 24**
**W-8133 Feldafing(DE)**

(54) **Dispositif de réglage à distance d'un ensemble d'émetteurs-récepteurs, notamment pour la reconfiguration des stations de base d'un réseau de radiotéléphone cellulaire.**

㊄ Ce dispositif comporte :
- des moyens de mesure d'un paramètre radioélectrique du filtre (11), ce paramètre étant un paramètre caractéristique du désalignement de ce filtre par rapport à une réponse fréquentielle ou temporelle de consigne, et
- des moyens pour modifier le réglage dudit filtre dans un sens réduisant ce désalignement, ces moyens étant des moyens asservis sur la mesure dudit paramètre.

Ledit paramètre radioélectrique peut notamment être le rapport d'ondes stationnaires d'entrée du filtre, la fonction de transfert ou la réponse impulsionnelle du filtre, ou encore le taux de distorsion du signal transmis.

Pour la mesure du paramètre radioélectrique, on peut notamment appliquer au filtre une série de fréquences pures localisées dans la bande sur laquelle le filtre doit être réglé, et/ou sur les flancs de cette bande puis régler le filtre par minimisation d'une fonction d'écart des valeurs du paramètre radioélectrique mesurées auxdites fréquences pures par rapport à des valeurs correspondantes idéales mémorisées, et/ou par symétrisation des valeurs du paramètre radioélectrique mesurées auxdites fréquences pures par rapport à au moins une fréquence centrale donnée.

FIG.7

La présente invention concerne un dispositif de réglage de la fréquence d'accord d'un émetteur et d'un récepteur, notamment pour la reconfiguration à distance des stations de base d'un réseau de radiotéléphonie cellulaire.

La reconfiguration d'un tel système de transmission est l'opération qui consiste à modifier les fréquences de travail d'un certain nombre des canaux radioélectriques constituant ce système.

Il en est notamment ainsi pour les stations de base des systèmes de radiotéléphonie cellulaire mobile : dans ces systèmes, une station de base contrôle un certain nombre de terminaux mobiles situés dans une zone ou ≪ cellule ≫ couverte par la station de base. ; un ≪ réseau cellulaire ≫ est constitué par la juxtaposition d'un certain nombre de ces cellules.

Afin d'éviter les perturbations radioélectriques entre éléments du réseau, il est impératif que deux cellules adjacentes quelconques du réseau fonctionnent sur des fréquences compatibles.

Dans ces conditions, à un réseau cellulaire est associée toute une gestion de la répartition des fréquences à l'intérieur de ce réseau. Cette gestion est d'autant plus complexe que chaque station de base comporte un nombre important de canaux, donc d'émetteurs distincts possédant chacun une fréquence propre (typiquement, les stations de base peuvent comporter jusqu'à 16 canaux et même plus).

Or il peut être nécessaire de modifier la répartition des fréquences. Tel est par exemple le cas lors d'une extension du réseau en vue d'une amélioration de la couverture géographique par addition de nouvelles stations de base, d'une augmentation du nombre de canaux des stations de base, etc.

Il est alors généralement indispensable de modifier la fréquence de travail de certains canaux, non seulement de la station de base considérée, mais également d'un certain nombre d'autres stations de base, du fait qu'une modification des fréquences d'une station peut faire ≪ tache d'huile ≫, de proche en proche, sur les fréquences des autres stations, obligeant ainsi à modifier la répartition des fréquences de la totalité du réseau ou, à tout le moins, d'une grande partie de celui-ci.

L'opération à effectuer à cet effet sur chacun des émetteurs et des récepteurs de chacune des stations de base concernées consiste à changer la fréquence centrale du canal d'émission et/ou de réception correspondant.

Cette opération est opérée, pour chaque canal, à deux niveaux.

En premier lieu, il convient de modifier la fréquence des oscillateurs locaux de transposition aux fréquences de travail. Mais, compte tenu du fait que ces oscillateurs sont généralement des dispositifs à synthèse de fréquence commandés numériquement, cette première modification ne présente en général pas de difficulté particulière.

En revanche, il convient également de modifier l'accord des filtres passe-bande d'émission et de réception autour de la nouvelle fréquence du canal. Ces filtres, dont la réponse est calculée pour présenter une sélectivité très marquée, contribuent en effet à la séparation des différents canaux de la station de base, et il est donc indispensable de les régler avec beaucoup de soin. On notera en particulier que, si l'on attribue aux différents canaux des bandes de fréquence adjacentes, toute perturbation éventuelle du réglage d'un filtre risque de produire, par empiètement des bandes voisines correspondantes, une perturbation des canaux voisins.

En général, ces filtres sont constitués soit de cavités résonantes accordées, soit de systèmes électroniques comportant un composant à impédance variable (diode à capacité variable par exemple).

Dans le premier cas, le réglage est opéré par déplacement d'un ou plusieurs plongeurs, dont l'enfoncement dans la cavité (ou dans les différentes cavités respectives, dans le cas d'un filtre à plusieurs pôles) détermine la fréquence d'accord ; dans le second cas, l'ajustement du filtre est réalisé par modification de la tension de polarisation de la diode à capacité variable.

Jusqu'à présent, cette opération de réglage des filtres est effectuée selon deux procédures, manuelle ou automatique.

La procédure manuelle consiste à envoyer un technicien sur le site des différentes stations à reconfigurer, avec des appareils de mesure adéquats, et à procéder aux réglages des filtres sur les fréquences imparties. Cette solution, outre sa lourdeur de mise en oeuvre (nécessité de déplacements, coût, ...) implique une durée de reconfiguration globale du réseau très importante, donc une indisponibilité de celui-ci pendant au minimum plusieurs heures.

La procédure automatique consiste à régler automatiquement les filtres d'après une loi programmée, déterminée par un pré-étalonnage de chaque filtre, donnant la fréquence centrale d'accord de celui-ci en fonction de la position du moteur pas-à-pas de réglage du (des) plongeur(s) (dans le cas d'un accord mécanique) ou de la grandeur électrique (courant ou tension) de polarisation appliquée aux diodes à capacité variable (dans le cas d'un accord électronique).

Ce pré-étalonnage permet d'établir une table, conservée en mémoire, donnant les positions des plongeurs ou les grandeurs électriques de commande pour les diverses valeurs de fréquence centrale du filtre, et tenant éventuellement compte d'une variable supplémentaire climatique, afin de prendre en compte la température de travail, mesurée par ailleurs, des éléments à régler.

Cette méthode, bien qu'elle puisse être mise en oeuvre de façon automatisée, présente l'inconvénient d'être difficilement applicable au réglage des filtres à bande étroite tels que ceux que l'on trouve dans les stations de base des systèmes de radiotéléphonie cellulaires les plus récents, où les canaux correspondent typiquement à une bande passante de l'ordre de 500 kHz, dans la bande des 900 MHz.

De plus, opérant en boucle ouverte, ce mode de réglage ne permet pas de prendre en compte les dérives dues, par exemple, au vieillissement, du fait de l'absence de toute information de contrôle en retour qui permettrait de vérifier l'exactitude du réglage effectué.

L'un des buts de l'invention est de remédier à ces inconvénients, en proposant un dispositif permettant une mise en oeuvre entièrement automatique de la reconfiguration du réseau.

En outre, comme on le verra, le dispositif de l'invention est un dispositif fonctionnant en boucle fermée, donc avec une rétroaction permettant de compenser tous les désalignements possibles, qu'ils soient déterminables (effets de la température) ou plus ou moins aléatoires (vieillissement plus ou moins important des composants, jeux mécaniques, etc.).

Comme on le verra, l'invention propose d'utiliser divers critères permettant d'ajuster automatiquement à une fréquence centrale de fonctionnement désirée un filtre hyperfréquence inséré dans un émetteur/récepteur.

Ces critères pourront correspondre à des mesures effectuées soit à partir du signal normalement transmis, soit à partir de signaux de tests spécifiques pouvant être élaborés par l'équipement à régler lui-même, c'est-à-dire, dans le cas d'un réseau de radiotéléphonie cellulaire, par la station de base elle-même.

Ainsi, dans tous les cas, l'équipement à modifier fonctionnera en banc de mesure pour sa propre modification.

De plus, en cours d'ajustement, il sera possible de connaître en temps réel l'effet de la dernière action effectuée, et donc de déterminer un algorithme d'ajustement optimal, de type heuristique et non plus seulement mathématique.

À cet effet, le dispositif de réglage de la fréquence d'accord d'un filtre selon l'invention comporte :
- des moyens de mesure d'un paramètre radioélectrique du filtre, ce paramètre étant un paramètre caractéristique du désalignement de ce filtre par rapport à une réponse fréquentielle ou temporelle de consigne, et
- des moyens pour modifier le réglage dudit filtre dans un sens réduisant ce désalignement, ces moyens étant des moyens asservis sur la mesure dudit paramètre.

Dans un premier mode de mise en oeuvre de l'invention, ledit paramètre est le rapport d'ondes stationnaires (ROS) à l'entrée du filtre. Dans un second mode de mise en oeuvre, ce paramètre est la fonction de transfert (si l'on se place dans le domaine fréquentiel) ou la réponse impulsionnelle (si l'on se place dans le domaine temporel) du filtre.

Dans l'un ou l'autre cas, pour la mesure du paramètre radioélectrique, on peut notamment appliquer au filtre une série de fréquences pures localisées dans la bande sur laquelle le filtre doit être réglé, et/ou sur les flancs de cette bande.

Il est alors possible de régler le filtre soit par minimisation d'une fonction d'écart des valeurs du paramètre radioélectrique mesurées auxdites fréquences pures par rapport à des valeurs correspondantes idéales mémorisées, soit par symétrisation des valeurs du paramètre radioélectrique mesurées auxdites fréquences pures par rapport à au moins une fréquence centrale donnée.

Dans un autre mode de mise en oeuvre de l'invention, ledit paramètre est le taux de distorsion, que l'on cherche alors à minimiser pour atteindre l'accord du filtre.

Avantageusement, on peut prévoir que les moyens de mesure mesurent plusieurs paramètres différents, les moyens pour modifier le réglage du filtre étant alors soit asservis successivement sur ces divers paramètres, soit asservis sur un critère composite combinant ces divers paramètres.

D'autres caractéristiques et avantages de l'invention apparaîtront à la lecture de la description détaillée ci-dessous, faite en référence aux dessins annexés, de divers modes de réalisation de l'invention.

La figure 1 montre, de façon schématique, l'étage de sortie (combineur d'émission) d'un émetteur à plusieurs canaux.

La figure 2 montre la répartition des réponses des filtres dans un combineur d'émission à canaux rapprochés.

La figure 3 montre la caractéristique de ROS en fonction de la fréquence, respectivement pour un filtre correctement réglé sur la fréquence centrale voulue et pour un filtre présentant un écart de réglage par rapport à cette même fréquence centrale.

La figure 4 est un exemple d'algorithme de réglage de l'un des canaux d'une station de base utilisant le ROS du filtre du combineur d'émission comme critère de réglage.

La figure 5 illustre schématiquement un ensemble émetteur/récepteur d'une station de base, dans lequel on utilise la distorsion du signal transmis comme critère de réglage du filtre, et ceci selon trois variantes de mise en oeuvre possibles.

La figure 6 est un exemple d'organigramme de réglage des filtres utilisant successivement comme critères le ROS d'entrée du filtre puis la distorsion du signal transmis.

La figure 7 est un schéma par blocs d'un ensemble émetteur/récepteur comportant une unité de commande utilisant comme critères de réglage le ROS et la distorsion, soit de façon cumulative, soit de façon combinée.

On va exposer un certain nombre de modes de réalisation de l'invention, utilisant divers critères de réglage des filtres tels que le ROS (Rapport d'Ondes Stationnaires), la fonction de transfert ou la réponse impulsionnelle de la chaîne d'émission/réception, ou encore la distorsion du signal transmis par cette même chaîne d'émission/réception.

Dans tous les cas, on supposera que les différents oscillateurs locaux ou synthétiseurs ont été préalablement positionnés à leurs valeurs respectives correctes, permettant ainsi la transposition en fréquence dans la bande voulue, et que le seul réglage restant à effectuer est donc celui des filtres à bande étroite assurant la séparation des différents canaux.

Par ailleurs, bien que la présente description soit essentiellement faite en considération des réglages des filtres d'émission de la station de base, l'homme du métier comprendra que l'on peut appliquer sans difficulté les mêmes principes de réglage, *mutatis mutandis,* aux réglages des filtres du récepteur de cette même station de base, ou au réglage des filtres de l'émetteur ou du récepteur de tout autre type d'émetteur-récepteur que l'on désire reconfigurer.

Enfin, bien que l'on ne décrive principalement que le réglage d'un filtre par canal, les enseignements de l'invention peuvent être étendus à un système dans lequel le canal reconfiguré possède plusieurs filtres étroits accordés sur la fréquence centrale de travail, par exemple un filtre à l'émission et un filtre à la réception, ou une pluralité de filtres successifs montés en série et commandables séparément.

Cette dernière éventualité s'applique en particulier, typiquement, aux réglages des filtres à plusieurs cellules, par exemple ceux comportant plusieurs plongeurs, qu'il devient possible de commander distinctement (il suffit d'isoler le mécanisme de commande du plongeur à régler), au lieu de procéder à un réglage commun avec un moteur unique combiné à une démultiplication, comme tel est le cas actuellement. Cette possibilité permet alors d'aboutir à un accord extrêmement fin des différents filtres de la chaîne d'émission/réception.

## Utilisation du ROS comme critère de réglage

Il est possible d'utiliser le ROS comme critère de réglage du filtre, car l'on sait qu'il existe une loi (théorique ou pratique) reliant à la valeur du ROS mesuré l'écart entre réglage idéal et réglage effectif du filtre.

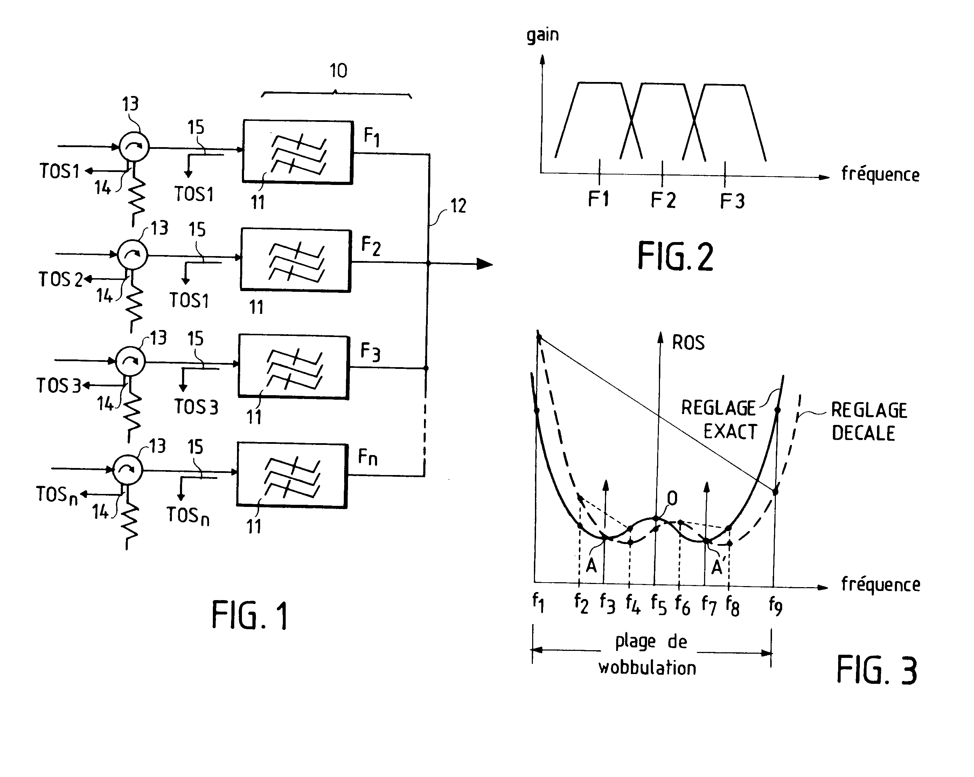

La figure 1 montre l'étage de sortie d'un émetteur, dans lequel un combineur d'émission 10 comporte une pluralité de filtres sélectifs 11 accordés sur des fréquences respectives $F_1$, $F_2$ ... $F_n$ dont les sorties sont combinées sur une ligne commune 12 reliée à l'antenne d'émission de la station de base.

Le ROS d'entrée de chacun des filtres 11 peut être par exemple mesuré au niveau du circulateur d'entrée 13 de chaque canal, au moyen d'une prise de test 14 reliée à un dispositif de mesure de ROS, de type en lui-même connu. Cette solution présente l'avantage, lorsqu'il existe déjà un circulateur, de ne pas surajouter d'élément sur la ligne de transmission.

Une autre possibilité consiste à utiliser un coupleur directif 15 ajouté sur la ligne d'entrée aboutissant à chacun des filtres 11. La mesure du ROS obtenue avec cette configuration présente l'avantage d'être moins liée à la qualité intrinsèque du circulateur, et donc de refléter plus exactement la valeur du ROS en entrée du seul filtre 11.

Par ailleurs, quelle que soit la configuration choisie, la mesure du ROS pourra être effectuée soit directement à partir du signal modulé, soit - de préférence - à partir d'un ensemble de fréquences pures localisées dans la bande sur laquelle le filtre doit être réglé et sur les flancs de cette bande.

Dans la première solution, le critère d'optimisation sera la minimisation du ROS mesuré.

Quant à la seconde solution, elle présente l'avantage d'un réglage plus précis, caractéristique particulièrement intéressante dans le cas où le combineur d'émission est un combineur à canaux rapprochés, comme on l'a illustré schématiquement sur la figure 2 : en effet, dans ce cas, la superposition des canaux aux points de recoupement entraîne une interdépendance des réglages des filtres, et il est donc nécessaire de régler isolément et de façon très précise chacun d'entre eux.

Les différentes fréquences pures peuvent notamment être obtenues par une wobbulation opérée dans la bande sur laquelle le filtre doit être réglé, comme illustré figure 3.

Cette wobbulation peut notamment résulter d'une commande particulière de l'oscillateur local ou du synthétiseur d'émission ; on désactive alors la transmission du signal modulé normal par une commande d'inhibition appropriée au modulateur, et on commande le VCO (oscillateur à fréquence commandée par tension) de celui-ci de façon appropriée.

Le critère d'optimisation sera alors, non plus la simple minimisation du ROS mesuré comme dans le cas précédent, mais une minimisation d'une fonction d'écart des différents ROS mesurés aux fréquences pures $f_i$ par rapport à des valeurs idéales de ROS mémorisées (valeurs de consigne), par exemple une minimisation de la fonction F suivante :

$$F = \sum_{i=0}^{n} \mid ROS_{mesuré}(f_i) - ROS_{idéal}(f_i) \mid \qquad (1)$$

Une autre possibilité consiste, au lieu d'effectuer un réglage par rapport à une consigne (l'ensemble des ROS idéaux mémorisés), à effectuer un réglage sans consigne, par optimisation de la symétrie des valeurs de ROS mesurées de part et d'autre d'un point.

Par exemple, si l'on prend l'exemple de la figure 3 qui donne la variation du ROS en fonction de la fréquence pure $f_1$ ... $f_9$ sur la plage de wobbulation choisie, on peut voir que tout déréglage du filtre par rapport à son réglage exact se traduit par des valeurs de ROS dissymétriques de part et d'autre de la fréquence centrale désirée, qui est ici $f_5$.

Le réglage peut alors être effectué en comparant les valeurs de ROS obtenues aux fréquences $f_1$ et $f_9$, ou $f_3$ et $f_7$, etc. et en ajustant le réglage pour que ces valeurs de ROS respectives soient les plus proches possibles.

La symétrisation peut se faire également par rapport à des minima de la courbe de ROS situés de part et d'autre de la fréquence centrale.

La symétrisation sera alors effectuée de part et d'autre des points A et A', qui sont eux-mêmes, si le réglage est exact, symétriques par rapport à la fréquence centrale $f_5$, c'est-à-dire par rapport au point O. On cherchera alors, dans cet exemple de la figure 3, à symétriser $f_2$ par rapport $f_4$, et $f_6$ par rapport à $f_8$, les fréquences des minima locaux A et A' étant respectivement $f_3$ et $f_7$.

Dans l'un ou l'autre cas, on pourra chercher à minimiser un critère de la forme :

$$\min(F) = \sum_{i=0}^{n} \mid ROS(f_{i1}) - ROS(f_{i2}) \mid \qquad (2)$$

où $f_{i1}$ et $f_{i2}$ sont des fréquences symétriques de part et d'autre de la fréquence centrale, ou de part et d'autre de minima ou de maxima locaux connus de la caractéristique de ROS en fonction de la fréquence.

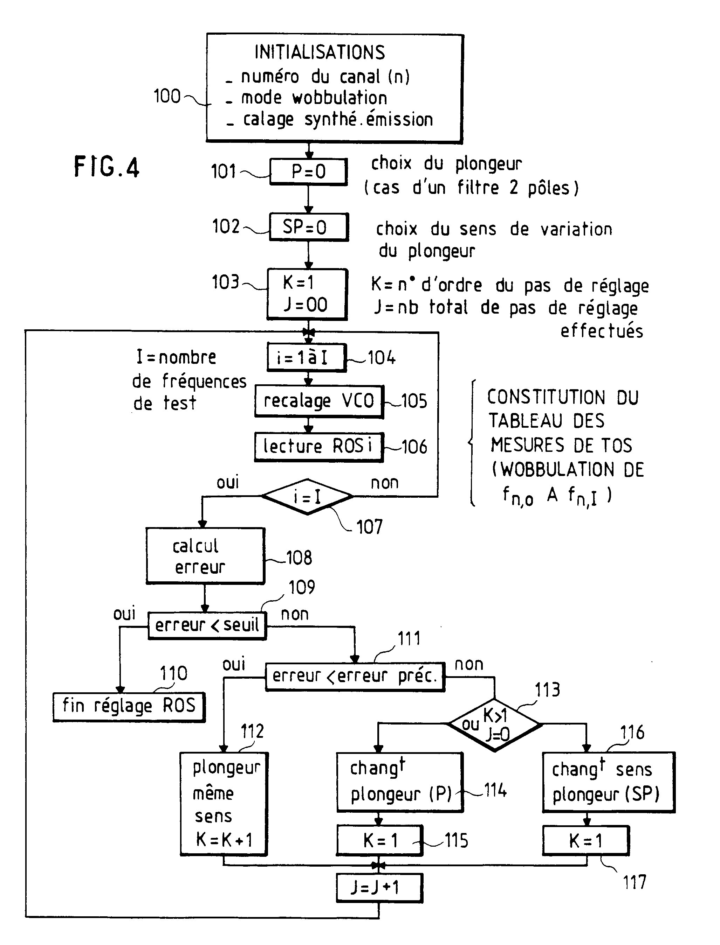

La figure 4 montre un exemple d'algorithme de réglage à partir d'un tel critère.

A l'étape 100, on procède à un certain nombre d'initialisations, à savoir : sélection du canal (n) à reconfigurer, passage en mode wobbulation (inhibition de la transmission des données et commande spécifique des VCOs) et calage des synthétiseurs d'émission sur les différentes fréquences pures choisies.

Cet exemple d'organigramme correspond à un réglage d'un filtre constitué d'une cavité résonante double ou de deux cavités résonantes (filtre à deux pôles) dans lequel le réglage se fait par ajustement de la profondeur de pénétration de plongeurs respectifs; on notera que, comme on le verra, l'invention permet de régler distinctement l'un et l'autre des plongeurs, alors que jusqu'à présent on se contentait généralement de régler simultanément ces deux plongeurs, ceux-ci étant liés entre eux par une démultiplication appropriée.

Après avoir, aux étapes 101 à 103, choisi le plongeur à régler, le sens de variation de ce plongeur et défini le numéro d'ordre du réglage dans ce sens de variation ainsi que le nombre de réglages effectués, on procède à la mesure des différentes valeurs de ROS d'entrée du filtre pour les I fréquences pures couvertes par la wobbulation (étapes itératives 104 à 107).

Une fois ce tableau de valeurs constitué et mémorisé, on calcule en 108 la fonction d'erreur F, par exemple à partir de l'une des relations (1) ou (2) exposées plus haut.

Si la valeur de cette fonction est inférieure à un seuil prédéterminé (étape 109), le réglage du filtre est considéré comme achevé (étape 110).

Dans le cas contraire, on examine si l'on a ou non réduit l'erreur par rapport à l'itération précédente (étape 111).

Dans l'affirmative, on continue à déplacer le plongeur dans le même sens (étape 112) et on procède à nouveau à une mesure des valeurs de ROS.

Dans la négative, on détermine (étape 113) si l'on est arrivé en bout de réglage avec ce plongeur, auquel cas il faudra changer de plongeur (étapes 114 et 115) et reprendre le processus avec l'autre plongeur. Dans le cas contraire, on se contente de changer le sens de progression du déplacement du plongeur (étapes 116 et 117) puis on reprend le même processus en recommençant dans ce sens inversé.

### Utilisation de la fonction de transfert comme critère de réglage

On peut procéder de la même façon que précédemment en utilisant pour le réglage du filtre non plus la mesure du ROS mais la mesure de la fonction de transfert du filtre (ou de la réponse impulsionnelle, qui est dans le domaine temporel la transformée de Fourier de la fonction de transfert dans le domaine fréquentiel).

Cette fonction de transfert peut par exemple être mesurée à l'aide d'un coupleur directionnel placé en sortie du filtre.

On notera que ce mode de mesure peut être difficile à mettre en oeuvre dans le cas où les signaux sont recombinés directement en sortie du filtre d'émission, car il faudrait alors prévoir des commutateurs ou relais hyperfréquences pour isoler la sortie du filtre à régler du reste du combineur.

Comme dans le cas du ROS, les mesures peuvent être effectuées soit sur le signal modulé soit, de préférence, sur un ensemble de fréquences pures, selon des procédures semblables à celles qui ont été présentées plus haut pour le ROS.

Il est d'ailleurs possible d'effectuer simultanément les mesures du ROS et de la fonction de transfert, la fonction d'écart combinant alors ces deux critères.

### Utilisation de la distorsion du signal comme critère de réglage

En variante ou en complément d'un critère basé sur le ROS et/ou sur la fonction de transfert, il est possible d'utiliser comme autre critère la distorsion du signal transmis, démodulé et échantillonné (dans le cas où ce signal est modulé numériquement).

Il est connu en effet que la fonction de transfert globale de l'ensemble de la chaîne de transmission (circuits d'émission, fonction de propagation et circuits de réception) peut être estimée à partir des échantillons successifs du signal transmis et démodulé, dès lors que l'échantillonnage est réalisé à une fréquence supérieure ou égale à $2/T_s$, où $T_s$ désigne le ≪ temps-symbole ≫, c'est-à-dire la durée pendant laquelle l'information présente à l'entrée du canal reste au même niveau, qu'il s'agisse de deux états binaires ou d'un signal multiniveau.

Le signal utilisé à cet effet sera, selon les caractéristiques du filtre, et plus particulièrement sa bande passante, ou bien un signal de mêmes caractéristiques que le signal normalement transmis, ou bien un signal présentant un débit numérique adapté à la bande passante du filtre.

Le signal restitué en réception, après démodulation en bande de base, ne présente plus tout à fait cette configuration à niveaux multiples, du fait de la distorsion (distorsion intersymbole).

Pour retrouver l'information, on procède à un échantillonnage à la cadence $1/T_s$. Cet échantillonnage fournit une valeur estimée de l'information transmise, ainsi qu'une estimation de l'erreur sur cette information.

En outre, on montre que si l'on procède à un échantillonnage supplémentaire, à une cadence $2/T_s$ ou plus, on peut obtenir une information plus riche, et notamment reconstituer la fonction de transfert de l'ensemble du système, incluant donc la fonction de transfert (ou la réponse impulsionnelle) du filtre à régler.

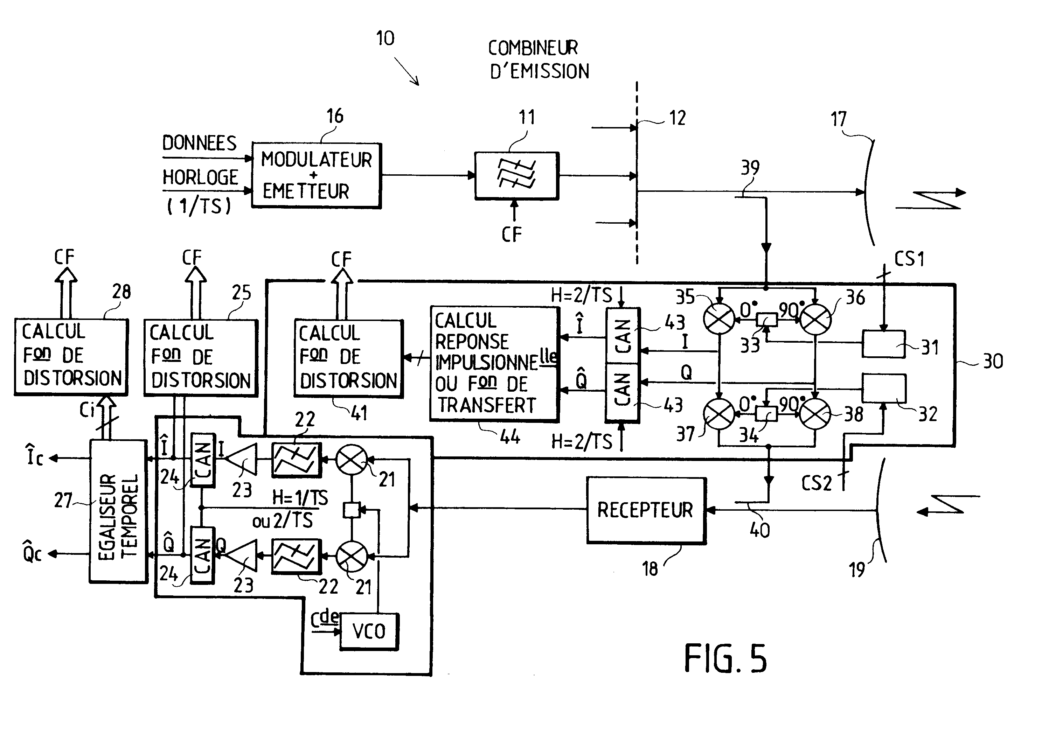

Sur la figure 5, on a représenté le schéma synoptique d'une station de base configurée de manière à obtenir une information de distorsion par trois modes d'analyse différents ; bien entendu, il est possible de n'utiliser, en fonction des besoins, que l'un ou l'autre de ces modes d'analyse, qui n'ont été rassemblés sur le schéma de la figure 5 que pour la commodité de la description.

Outre le combineur d'émission 10, comprenant une série de filtres 11 à bande étroite, on trouve l'ensemble 16 de modulation en bande de base et d'émission de puissance proprement dite délivrant le signal modulé (le signal modulant comportant par exemple des données numériques transmises à une cadence d'horloge de fréquence $1/T_s$) et une antenne d'émission 17 rayonnant les signaux des différents canaux, combinés sur la ligne d'émission 12.

La partie réception comporte, quant à elle, un récepteur 18 recevant les signaux captés par l'antenne de réception 19 et un démodulateur 20 de type classique, qui est dans l'exemple représenté un démodulateur en quadrature comportant sur chaque voie un mélangeur 21 recevant la fréquence de l'oscillateur local, un filtre passe-bas 22, un amplificateur 23 et un convertisseur analogique/numérique 24. L'une des voies donne une estimation du signal I, et l'autre voie une estimation du signal Q. Ces signaux I et Q contiennent l'information transmise à laquelle s'ajoute la distorsion introduite par le canal de transmission.

Un premier mode de mise en oeuvre de l'invention utilise directement ces signaux I et Q, sous leur forme numérisée $\hat{I}$ et $\hat{Q}$ délivrée en sortie du démodulateur 20, pour calculer la fonction de distorsion, au moyen d'un circuit 25 délivrant une commande CF de réglage du filtre correspondant à ce canal.

Un second mode de mise en oeuvre consiste, lorsque la station est équipée d'un dispositif dit ≪ égaliseur temporel ≫ 27, c'est-à-dire un dispositif permettant de reconstituer une fonction de transfert idéale, à utiliser pour le calcul de la distorsion les coefficients $C_i$ délivrés par cet égaliseur, ce calcul étant effectué dans un circuit 28 délivrant un signal de commande CF.

Cet égaliseur temporel est en fait un filtre transverse à coefficient $(C_i)$ variables auto-ajustables. La fonction de distorsion pourra être par exemple la fonction suivante :

$$f(D) = \sum_{i=-n}^{+m} |C_i|, \text{ avec } i \neq 0 \qquad (3)$$

$C_i$ étant les coefficients (complexes) du filtre, notés $C_{-n}$ à $C_{+m}$. Si l'on arrive à annuler une telle fonction $f(D)$, ceci signifie que la distorsion est nulle, et donc que l'accord du filtre est parfait.

Un troisième mode de mise en oeuvre consiste à utiliser une carte de test radio 30 (qui est souvent présente dans les stations de base de radiotéléphonie) afin d'assurer, outre les fonctions de test, un calcul de la distorsion.

Une telle carte assure, moyennant une double transposition en fréquence, un rebouclage entre émission et réception. Elle comporte deux oscillateurs locaux à synthèse de fréquence 31, 32 commandés respectivement par des signaux $CS_1$ et $CS_2$ et dont les sorties sont appliquées à des coupleurs 0/90˚ respectifs 33, 34 alimentant une série de mélangeurs 35, 36, 37 et 38 recevant en entrée soit le signal émis prélevé par un coupleur directionnel 39 en aval du combineur d'émission (mélangeurs 35 et 36) et délivrant en sortie le signal transmis au récepteur 18 par l'intermédiaire du coupleur directionnel 40.

Les informations I et Q obtenues en sortie, correspondant respectivement aux valeurs analogiques de l'estimation du signal d'information et de l'estimation de l'erreur sur ce signal d'information, sont appliquées à des convertisseurs analogique/numérique respectifs 43 cadencés à la fréquence $2/T_s$. Les valeurs numériques $\hat{I}$ et $\hat{Q}$ obtenues en sortie sont appliquées à un circuit 44 de calcul de la fonction de transfert, délivrant une information représentative de la distorsion à un circuit 41 produisant le signal CF de commande du filtre du canal correspondant.

Pour procéder au réglage, on commande les synthétiseurs de transposition 31, 32 de la carte de test 30 sur le canal de la station que l'on veut régler, et l'on peut, par exemple, obtenir la fonction de distorsion calculée, permettant de disposer de l'information de commande du filtre approprié, à partir d'une estimation de la réponse impulsionnelle échantillonnée du canal global et par comparaison de cette réponse avec une réponse idéale, l'écart étant dû au déréglage du filtre en cours d'ajustement.

En variante, au lieu de la réponse impulsionnelle, on peut effectuer une comparaison des fonctions de transfert.

On voit ainsi que, dans l'un ou l'autre des trois cas exposés, on dispose d'un système rebouclé, incluant la totalité de la chaîne d'émission et de réception avec une loi d'ajustement permettant de compenser par approximations successives le déréglage du filtre du canal sélectionné.

*Utilisation d'un critère de réglage mixte*

Dans un exemple préférentiel de mise en oeuvre, on utilise successivement deux des critères développés ci-dessus, à savoir le critère du ROS pour un premier réglage grossier, puis le critère de distorsion pour un second réglage fin.

Pour chacune des phases de réglages, l'algorithme utilisé pourra être de type heuristique, l'évolution de la fonction d'erreur (liée au ROS dans la première phase, à la distorsion dans la seconde phase) permettant de déterminer le sens de la commande suivante des systèmes de réglage.

On pourrait également envisager, bien que cela soit plus complexe à mettre en oeuvre, un algorithme de type mathématique, à condition de connaître une loi mathématique reliant l'élément commandé (c'est à dire l'enfoncement du plongeur du filtre ou la grandeur électrique de polarisation de la diode à capacité variable) et le paramètre de commande, c'est-à-dire la fonction d'écart.

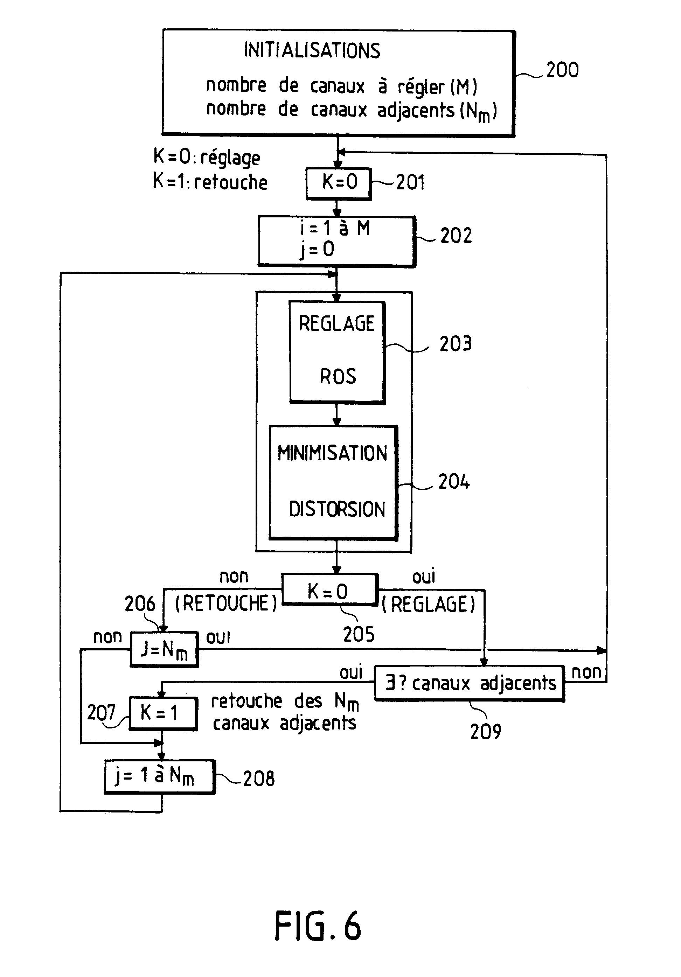

Un exemple d'algorithme heuristique de ce type est présenté figure 6.

Après une étape 200 d'initialisation (nombre de canaux à régler M et nombre de canaux adjacents $N_m$), on procède aux ajustements des filtres, en distinguant le ≪ réglage ≫ du canal et les ≪ retouches ≫ devant être apportées aux canaux adjacents du fait de ce ≪ réglage ≫, afin que la règle fondamentale selon laquelle des cellules voisines ne possèdent jamais de fréquences incompatibles reste respectée pour tous les canaux du réseau.

On positionne d'abord le système en position ≪ réglage ≫ (étape 201), puis l'on analyse successivement les M canaux principaux à régler (étape 202).

Pour chacun de ces canaux, on procède à un réglage en deux étapes, tout d'abord à partir du ROS, en utilisant un algorithme semblable à celui exposé plus haut et illustré en référence à la figure 4 (étape 203), puis à un réglage fin par utilisation du critère de minimisation de la distorsion (étape 204).

On notera que l'on pourrait utiliser diverses variantes de ces étapes 203, 204, par exemple une première phase avec utilisation du critère du ROS combinée à la fonction de transfert, puis une seconde phase utilisant le critère de distorsion, ou encore une phase unique avec un critère composite associant ROS et distorsion.

On répète ensuite l'opération pour les $N_m$ canaux adjacents du $m^{ième}$ canal principal considéré (opération de ≪ retouche ≫, correspondant aux étapes 205 à 208). Cette retouche sera nécessaire lorsque l'écart de fréquence entre canaux adjacents sera faible en comparaison de la bande passante des filtres de ces canaux

Lorsque l'on a déterminé (étape 209) que tous les canaux adjacents du canal considéré ont été retouchés, on repasse alors en mode ≪ réglage ≫ et l'on recommence l'opération pour le canal principal suivant.

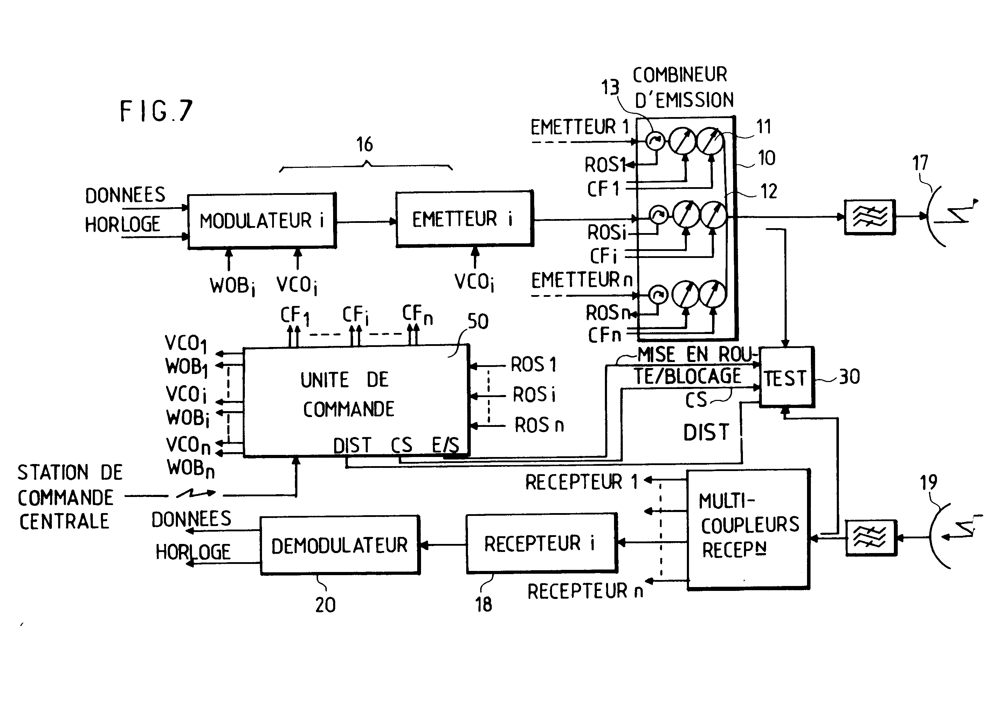

La figure 7 représente un dispositif permettant de mettre en oeuvre un tel algorithme.

Sur cette figure, les références numériques semblables à celles utilisées sur la figure 5 désignent des éléments similaires.

En particulier, on retrouve l'ensemble modulateur/émetteur 16, le combineur d'émission 11, l'antenne d'émission 17, l'antenne de réception 19, le récepteur 18 et le démodulateur 20, ainsi que la carte de test radio 30, utilisables éventuellement pour déterminer la fonction de distorsion de la chaîne de transmission.

L'algorithme de la figure 4, ou celui de la figure 6 dans le cas d'un critère mixte, est exécuté au sein d'une unité de commande 50 recevant en entrée :
- les mesures de ROS : $ROS_1$ ... $ROS_i$ ... $ROS_n$ des filtres d'entrée 11 du combineur d'émission 10, et
- la fonction de distorsion DIST, par exemple produite par la carte de test 30, et délivrant en sortie :
- les signaux de commande de filtre $CF_1$ ... $CF_i$... $CF_n$, chacune de ces commandes pouvant être éventuellement démultipliée en signaux distincts pour la commande séparée de chacune des cavités de chacun des filtres 11,
- les signaux de commande de l'oscillateur variable $VCO_1$ ... $VCO_i$ ... $VCO_n$ de chacun des modulateurs,
- les signaux $WOB_1$ ... $WOB_i$ ... $WOB_n$ d'inhibition de la transmission des données au modulateur et de passage en position de wobbulation,
- la commande CS des synthétiseurs de la carte de test, et
- la sélection mise en route/blocage appliquée également à cette carte de test.

La mise en oeuvre de cette unité de commande sera elle-même déclenchée et programmée par des ordres de configuration envoyés par une télétransmission appropriée depuis une station de commande centrale envoyant à l'unité de commande 50 les valeurs des fréquences du nouveau plan de répartition et déclenchant l'exécution par celle-ci de la reconfiguration de la station de base.

**Revendications**

1. Un dispositif de réglage de la fréquence d'accord d'un filtre (11) d'émetteur ou de récepteur, notamment pour la reconfiguration à distance des stations de base d'un réseau de radiotéléphonie cellulaire, caractérisé en ce qu'il comporte :
   - des moyens de mesure d'un paramètre radioélectrique du filtre, ce paramètre étant un paramètre caractéristique du désalignement de ce filtre par rapport à une réponse fréquentielle ou temporelle de consigne, et
   - des moyens pour modifier le réglage dudit filtre dans un sens réduisant ce désalignement, ces moyens étant des moyens asservis sur la mesure dudit paramètre.

2. Le dispositif de la revendication 1, dans lequel ledit paramètre est le rapport d'ondes stationnaires à l'entrée du filtre.

3. Le dispositif de la revendication 1, dans lequel ledit paramètre est la fonction de transfert ou la réponse impulsionnelle du filtre.

4. Le dispositif de l'une des revendication 2 et 3, dans lequel, pour la mesure du paramètre radioélectrique, on applique au filtre une série de fréquences pures ($f_1$ ... $f_9$) localisées dans la bande sur laquelle le filtre doit être réglé, et/ou sur les flancs de cette bande.

5. Le dispositif de la revendication 4, dans lequel on règle le filtre par minimisation d'une fonction d'écart des valeurs du paramètre radioélectrique mesurées auxdites fréquences pures par rapport à des valeurs correspondantes idéales mémorisées.

6. Le dispositif de la revendication 4, dans lequel on règle le filtre par symétrisation des valeurs du paramètre radioélectrique mesurées auxdites fréquences pures par rapport à au moins une fréquence centrale ($f_5$ ; $f_3$, $f_7$) donnée.

7. Le dispositif de la revendication 1, dans lequel ledit paramètre est le taux de distorsion du signal transmis.

8. Le dispositif de la revendication 1, dans lequel les moyens de mesure mesurent plusieurs paramètres différents et les moyens pour modifier le réglage du filtre sont des moyens asservis successivement sur ces divers paramètres.

9. Le dispositif de la revendication 1, dans lequel les moyens de mesure mesurent plusieurs paramètres différents et les moyens pour modifier le réglage du filtre sont des moyens asservis sur un critère composite combinant ces divers paramètres.

**FIG. 1**

**FIG.2**

**FIG. 3**

EP 0 466 080 A1

FIG.4

Flowchart:

INITIALISATIONS
- numéro du canal (n)
- mode wobbulation
- calage synthé. émission

100

101 — P=0 — choix du plongeur (cas d'un filtre 2 pôles)

102 — SP=0 — choix du sens de variation du plongeur

103 — K=1 / J=00 — K= n° d'ordre du pas de réglage / J=nb total de pas de réglage effectués

I=nombre de fréquences de test

i=1 à I — 104
recalage VCO — 105
lecture ROSi — 106

CONSTITUTION DU TABLEAU DES MESURES DE TOS (WOBBULATION DE $f_{n,o}$ A $f_{n,I}$ )

oui / non — i=I — 107

calcul erreur — 108

oui / non — erreur < seuil — 109

fin réglage ROS — 110

erreur < erreur préc. — 111

ou K>1 J=0 — 113

plongeur même sens K=K+1 — 112

chang$^t$ plongeur (P) — 114

chang$^t$ sens plongeur (SP) — 116

K=1 — 115

K=1 — 117

J=J+1

12

COMBINEUR
D'EMISSION

10

DONNEES
MODULATEUR
+
EMETTEUR

16

HORLOGE
( 1/TS )

11

CF

12

17

39

CALCUL
F°⁰ DE
DISTORSION

28

CF

CALCUL
F°⁰ DE
DISTORSION

25

CF

CALCUL
F°⁰ DE
DISTORSION

CF

41

CALCUL
REPONSE
IMPULSIONNE^lle
OU F°⁰ DE
TRANSFERT

44

H=2/TS

Î

CAN CAN

43

I

Q

CAN CAN

43

Q̂

H=2/TS

35

0°   90°

36

CS1

33

31

30

37   34

38

32

0°   90°

Îc

27

Î

24

CAN

I

23

22

H=1/TS
ou 2/TS

21

CS2

EGALISEUR TEMPOREL

Ci

Q̂c

Q̂

24

CAN

Q

23

22

21

RECEPTEUR

40

18

19

Cde

VCO

FIG. 5

EP 0 466 080 A1

13

INITIALISATIONS

nombre de canaux à régler (M)
nombre de canaux adjacents ($N_m$)

— 200

K=0: réglage
K=1: retouche

K=0 —201

i = 1 à M
j = 0

— 202

REGLAGE

ROS

203

MINIMISATION

DISTORSION

204

non
(RETOUCHE)

K = 0

oui
(REGLAGE)

206

205

non        oui

$J = N_m$

oui

∃? canaux adjacents

non

207        K = 1        retouche des $N_m$
canaux adjacents

209

j = 1 à $N_m$ — 208

FIG. 6

14

FIG.7

COMBINEUR D'EMISSION

EMETTEUR 1
ROS1
CF1
EMETTEUR n
ROSn
CFn
ROSi
CFi

DONNEES
HORLOGE

MODULATEUR i
WOBi
VCOi

EMETTEUR i
VCOi

TEST 30

MISE EN ROUTE/BLOCAGE
CS
DIST

MULTI-COUPLEURS RECEPN

RECEPTEUR 1
RECEPTEUR i
RECEPTEUR n

DEMODULATEUR
DONNEES
HORLOGE

UNITE DE COMMANDE
DIST CS E/S
ROS 1
ROSi
ROS n
CF1
CFi
CFn
VCO1
WOB1
VCOi
WOBi
VCOn
WOBn
50

STATION DE COMMANDE CENTRALE

17
19
11
10
12
13
16
18
20

Office européen
des brevets

**RAPPORT DE RECHERCHE
EUROPEENNE**

Numéro de la demande

**EP 91 11 1356**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | INTERNATIONAL SWITCHING SYMPOSIUM 1990, MAI 28 JUIN 1 1990, VOL. 6, PAGES 195-198, STOCKHOLM, &T NEXT GENERATION DIGITAL CELLULAR BASE STATION TECHNOLOGY" <br> * page 196, colonne de droite, ligne 5 - ligne 16 * <br> – – – | 1 | H 03 J 7/02 |
| A | EP-A-0 357 876   (AEG OLYMPIA AKTIENGESELLSCHAFT) <br> * colonne 3, ligne 8 - ligne 20 * <br> – – – | 5 | |
| A | EP-A-0 239 219   (THE MARCONI COMPANY LIMITED) <br> * colonne 4, ligne 21 - ligne 53 * <br> – – – – – | 9 | |

| | | | DOMAINES TECHNIQUES RECHERCHES (Int. Cl.5) |
|---|---|---|---|
| | | | H 03 J <br> H 04 Q <br> H 03 H |

Le présent rapport de recherche a été établi pour toutes les revendications

| Lieu de la recherche | Date d'achèvement de la recherche | Examinateur |
|---|---|---|
| La Haye | 20 septembre 91 | PEETERS M.M.G. |

CATEGORIE DES DOCUMENTS CITES
X : particulièrement pertinent à lui seul
Y : particulièrement pertinent en combinaison avec un
    autre document de la même catégorie
A : arrière-plan technologique
O : divulgation non-écrite
P : document intercalaire
T : théorie ou principe à la base de l'invention

E : document de brevet antérieur, mais publié à la
    date de dépôt ou après cette date
D : cité dans la demande
L : cité pour d'autres raisons
-----------------------------------------------------------------------
& : membre de la même famille, document
    correspondant